# EUROPEAN PATENT APPLICATION

(11) **EP 3 263 648 A1**
(43) Date of publication of application: **03.01.2018**
(21) Application number: 16754993.0
(22) Date of filing: 23.02.2016
(51) Int. Cl.: C08L 83/07, C08K 3/00, C08L 83/05, H01L 23/29, H01L 23/31

(54) **CURABLE GRANULAR SILICONE COMPOSITION AND METHOD FOR PREPARING SAME**

(30) Priority: 25.02.2015 JP 2015034941
(71) Applicant: Dow Corning Toray Co., Ltd., Tokyo 100-0004 (JP)
(72) Inventor: YAMAZAKI, Ryosuke, Ichihara-shi Chiba 299-0108 (JP); IMAIZUMI, Toru, Ichihara-shi Chiba 299-0108 (JP); OZAKI, Kouichi, Ichihara-shi Chiba 299-0108 (JP)
(74) Representative: Murgitroyd & Company
(86) International application number: PCT/JP2016/000959
(87) International publication number: WO 2016/136243

(57) **Abstract**

The curable granular silicone composition of the present invention comprises: (A) hot meltable silicone fine particles having a hydrosilylation reactive group and/or radical reactive group, with a softening point of 30°C or higher; (B) a filler that does not have a softening point or does not soften below the softening point of the aforementioned component (A); and (C) a curing agent, and is preferably in a pellet form. The curable granular silicone composition of the present invention has hot melt properties, and has excellent handling workability and curability.

## Description

### TECHNICAL FIELD

The present invention relates to a curable granular silicone composition and a method for manufacturing thereof.

### BACKGROUND ART

A curable silicone composition is used in a wide range of industrial fields because a cured product with excellent heat resistance, cold resistance, electrical insulating properties, weather resistance, water repellency, and transparency is formed by curing. Furthermore, the cured product is less likely to discolor compared to other organic materials and have less decrease in physical properties, and therefore, is preferably used in optical materials.

For example, Patent Document 1 discloses a silicone resin composition for a light emitting diode (LED) element comprising: a silicone resin having at least two silicon atom-bonded alkenyl groups in a molecule, an organohydrogensilane and/or organohydrogenpolysiloxane having at least two silicon atom-bonded hydrogen atoms in a molecule, and an addition reaction catalyst. Furthermore, Patent Document 2 discloses a mixed powder for sealing a light emitting device comprising: a phosphor and a silicone resin powder in a semi-cured state by primary crosslinking.

However, Patent Document 1 does not disclose or suggest using a silicone resin composition in granular form. On the other hand, Patent Document 2 discloses a mixed powder comprising a silicone resin powder and phosphor, but the silicone resin powder can be cured itself, and therefore controlling the curing reaction is difficult, and Patent Document 2 does not disclose or suggest adding a curing agent.

### CITATION LIST

### PATENT DOCUMENT

Patent Document 1: Japanese Unexamined Patent Application Publication No. 2004-186168
Patent Document 2: Pamphlet of International Patent Application Publication No. 2013/080596

### SUMMARY OF INVENTION

### TECHNICAL PROBLEM

An object of the present invention is to provide a curable granular silicone composition with hot melt properties and excellent handling workability and curability. Furthermore, another object of the present invention is to provide a method to efficiently manufacture the curable granular silicone composition.

### SOLUTION TO PROBLEM

The curable granular silicone composition of the present invention comprises:
(A) hot meltable silicone fine particles having a hydrosilylation reactive group and/or radical reactive group, with a softening point of 30°C or higher;
(B) a filler that does not have a softening point or does not soften below the softening point of the aforementioned component (A); and
(C) a curing agent.

The hydrosilylation reactive group in component (A) is preferably an alkenyl group with 2 to 20 carbon atoms and/or silicon-bonded hydrogen atom, and the radical reactive group in component (A) is preferably an alkyl group with 1 to 20 carbon atoms, alkenyl group with 2 to 20 carbon atoms, group containing acrylic, group containing methacrylic, or silicon-bonded hydrogen atom.

Component (A) is preferably (A₁) a resinous organopolysiloxane, (A₂) a crosslinked organopolysiloxane formed by partially crosslinking at least one type of organopolysiloxane, (A₃) a block copolymer formed from a resinous organosiloxane block and a linear organosiloxane block, or silicone fine particles formed from a mixture of two types or more thereof.

The average particle size of component (A) is preferably 1 to 5000 µm.

Furthermore, component (B) is preferably a reinforcing filler, white pigment, heat conductive filler, electrically conductive filler, phosphor, or a mixture of two types or more thereof, and the average particle size is preferably 1 nm to 500 µm.

The amount of component (B) is preferably 10 to 3000 parts by mass with regard to 100 parts by mass of component (A).

The curable granular silicone composition of the present invention is preferably in a pellet form.

Furthermore, the method for manufacturing the curable granular silicone composition of the present invention is characterized by powder mixing components comprising:
(A) hot meltable silicone fine particles having a hydrosilylation reactive group and/or radical reactive group, with a softening point of 30°C or higher;
(B) a filler that does not have a softening point or does not soften below the softening point of the aforementioned component (A); and
(C) a curing agent,
at a temperature below the softening point of component (A).

Furthermore, the method for molding the cured product of the present invention is characterized by comprising the following steps (I) to (III):
(I) a step of heating and melting the curable granular silicone composition at a temperature higher than the softening point of component (A);
(II) a step of injecting the curable silicone composition obtained in step (I) into a metal mold; and
(III) a step of curing the curable silicone composition injected in step (II).

### ADVANTAGEOUS EFFECTS OF INVENTION

The curable granular silicone composition of the present invention has hot melt properties, and has excellent handling workability and curability. Furthermore, the manufacturing method of the present invention can efficiently manufacture the curable granular silicone composition.

### DESCRIPTION OF EMBODIMENTS

### [Curable granular silicone composition]

Component (A) is a hot meltable silicone fine particles that provides good hot melt properties to the present composition, cures by curing agent (C), has a softening point of 30°C or higher, and has a hydrosilylation reactive group and/or radical reactive group.

Examples of the hydrosilylation reactive group in component (A) include alkenyl groups with 2 to 20 carbon atoms such as a vinyl group, allyl groups, butenyl groups, pentenyl groups, hexenyl groups, heptenyl groups, octenyl groups, nonenyl groups, decenyl groups, undecenyl groups, dodecenyl groups, and the like, and silicon-bonded hydrogen atoms. The hydrosilylation reactive group is preferably an alkenyl group. The alkenyl group can be straight chain or branched chain, and preferably is a vinyl group or hexenyl group. Component (A) preferably has at least two hydrosilylation reactive groups in a molecule.

Examples of the group bonded to a silicon atom other than the hydrosilylation reactive group in component (A) include alkyl groups with 1 to 20 carbon atoms, halogen-substituted alkyl groups with 1 to 20 carbon atoms, aryl groups with 6 to 20 carbon atoms, halogen-substitued aryl groups with 6 to 20 carbon atoms, aralkyl groups with 7 to 20 carbon atoms, alkoxy groups, and hydroxyl groups. Specific examples include alkyl groups such as methyl groups, ethyl groups, propyl groups, butyl groups, pentyl groups, hexyl groups, heptyl groups, octyl groups, nonyl groups, decyl groups, undecyl groups, dodecyl groups, and the like; aryl groups such as phenyl groups, tolyl groups, xylyl groups, naphthyl groups, anthracenyl groups, phenanthryl groups, pyrenyl groups, and the like; aralkyl groups such as phenethyl groups, phenylpropyl groups, and the like; the aforementioned groups where part or all of the hydrogen atoms bonded to the group are substituted with a halogen atom such as chlorine atom, bromine atom, or the like; and alkoxy groups such as methoxy groups, ethoxy groups, propoxy groups, and the like. In particular, a phenyl group or hydroxyl group is preferable.

Futhermore, examples of the radical reactive group in component (A) include alkyl groups with 1 to 20 carbon atoms such as methyl groups, ethyl groups, propyl groups, butyl groups, pentyl groups, hexyl groups, heptyl groups, octyl groups, nonyl groups, decyl groups, undecyl groups, dodecyl groups, and the like; alkenyl groups with 2 to 20 carbon atoms such as vinyl groups, allyl groups, butenyl groups, pentenyl groups, hexenyl groups, heptenyl groups, octenyl groups, nonenyl groups, decenyl groups, undecenyl groups, dodecenyl groups, and the like; groups containing acrylic such as 3-acryloxypropyl groups, 4-acryloxybutyl groups, and the like; groups containing methacrylic such as 3-methacryloxypropyl groups, 4-methacryloxybutyl groups, and the like; and silicon-bonded hydrogen atoms. The radical reactive group is preferably an alkenyl group. The alkenyl group can be straight chain or branched chain, and preferably is a vinyl group or hexenyl group. Component (A) preferably has at least two radical reactive groups in a molecule.

Examples of the group bonded to a silicon atom other than the radical reactive group in component (A) include halogen-substituted alkyl groups with 1 to 20 carbon atoms, aryl groups with 6 to 20 carbon atoms, halogen-substitued aryl groups with 6 to 20 carbon atoms, aralkyl groups with 7 to 20 carbon atoms, alkoxy groups, and hydroxyl groups, and the same groups as the described above. In particular, a phenyl group or hydroxyl group is preferable.

Component (A) itself has hot melt properties, and is cured by curing agent (C) described later. Component (A) is preferably
(A₁) a resinous organopolysiloxane,
(A₂) a crosslinked organopolysiloxane formed by crosslinking at least one type of organopolysiloxane,
(A₃) a block copolymer formed from a resinous organosiloxane block and a linear organosiloxane block,
or silicone fine particles formed from a mixture of two types or more thereof.

Component (A₁) is a resinous organopolysiloxane having a hydrosilylation reactive group and/or radical reactive group, and is preferably a resinous organopolysiloxane with hot melt properties having an aryl group and having a large number of T units or Q units. Examples of component (A₁) include any combination of triorganosiloxy units (M unit) (the organo groups are methyl groups alone or methyl groups, vinyl groups, or phenyl groups.), diorganosiloxy units (D unit) (the organo groups are methyl groups alone or methyl groups, vinyl groups, or phenyl groups.) monoorganosiloxy units (T unit) (the organo groups are methyl groups, vinyl groups, or phenyl groups.) and siloxane units (Q unit), such as MQ resin, MDQ resin, MTQ resin, MDTQ resin, TD resin, TQ resin, and TDQ resin. Note that component (A₁) preferably has at least two hydrosilylation reactive groups and/or radical reactive groups in a molecule, and 10 mol% or more of all organic groups in the molecule are aryl groups.

Furthermore, component (A₂) is formed by crosslinking at least one type of organopolysiloxane, and therefore, cracking is less likely to occur and cure shrinkage can be decreased when curing by curing agent (C). Herein, "crosslinking" refers to linking the organopolysiloxane which is a raw material by hydrosilylation reaction, condensation reaction, radical reaction, high energy ray reaction, and the like. Examples of the hydrosilylation reactive group or radical reactive group (including high energy ray reactive group) include the same groups as described above, and examples of a condensation reactive group include hydroxyl groups, alkoxy groups, and acyloxy groups.

The units configuring component (A₂) are not particularly limited, and examples thereof include siloxane units and siloxane units containing a silalkylene group, and furthermore, preferably has resinous polysiloxane units and a linear polysiloxane units in the same molecule because sufficient hardness and mechanical strength are provided to the obtained cured product. In other words, component (A₂) is preferably a crosslinked product of resin (resinous) organopolysiloxane and linear (including straight chain or branched chain) organopolysiloxane. By introducing the resinous organopolysiloxane structure - linear organopolysiloxane structure in component (A₂), component (A₂) indicates good hot melt properties and also good curability by curing agent (C).

Component (A₂) is any one of
(1) a product of a hydrosilylation reaction of an organopolysiloxane having at least two alkenyl groups in a molecule and an organopolysiloxane having at least two silicon-bonded hydrogen atoms in a molecule, and linked by alkylene-bonding the resinous organopolysiloxane structure - linear organopolysiloxane structure in the molecule,
(2) a product of a radical reaction by an organic peroxide of at least two types of organopolysiloxane having at least two radical reactive groups in a molecule, and linked by siloxane-bonding or alkylene-bonding the resinous organopolysiloxane structure - linear organopolysiloxane structure in the molecule, and
(3) a product of a condensation reaction of at least two types of organopolysiloxanes, and linked by siloxane-bonding (-Si-O-Si-) the resinous organopolysiloxane structure - linear organopolysiloxane structure. In the component (A₂), the organopolysiloxane portion with a resinous structure - linear structure has a structure linked by an alkylene group or a new siloxane bond, and therefore, hot melt properties are remarkably improved.

In (1) and (2), examples of the alkylene group contained in component (A₂) include alkenyl groups with 2 to 20 carbon atoms such as ethylene groups, propylene groups, butylene groups, pentylene groups, hexylene groups, and the like, and the groups may be a straight chain or branched chain, and are preferably an ethylene group or a hexylene group.

The crosslinked product of the resinous organopolysiloxane and the linear (including straight chain or branched chain) organopolysiloxane is configured by the siloxane unit and siloxane unit containing a silalkylene group, for example.
M unit: siloxane unit represented by R¹R²₂SiO_{1/2},
D unit: siloxane unit represented by R¹R²SiO_{2/2},
R³M/R³D unit: at least one type of siloxane unit selected from a siloxane unit containing a silalkylene group represented by R³_{1/2}R²₂SiO_{1/2} and siloxane unit containing a silalkylene group represented by R³_{1/2}R²SiO_{2/2}, and
T/Q unit: at least one type of siloxane unit selected from a siloxane unit represented by R²SiO_{3/2} and a siloxane unit represented by SiO_{4/2}.

In the formula, each R¹ is independently an alkyl group with 1 to 20 carbon atoms, halogen-substituted alkyl group with 1 to 20 carbon atoms, alkenyl group with 2 to 20 carbon atoms, aryl group with 6 to 20 carbon atoms, halogen-substituted aryl group with 6 to 20 carbon atoms, or aralkyl group with 7 to 20 carbon atoms, and examples include the same groups as described above. R¹ is preferably a methyl group, vinyl group, or phenyl group. However, of all the siloxane units, at least two of R¹ are preferably alkenyl groups.

Furthermore, in the formula, each R² is independently an alkyl group with 1 to 20 carbon atoms, halogen-substituted alkyl group with 1 to 20 carbon atoms, aryl group with 6 to 20 carbon atoms, halogen-substituted aryl group with 6 to 20 carbon atoms, or aralkyl group with 7 to 20 carbon atoms, and examples include the same groups as the aforementioned R¹. R² is preferably a methyl group or phenyl group.

Furthermore, in the formula, R³ is a straight chain or branched chain alkylene group with 2 to 20 carbon atoms, bonded to a silicon atom in a different siloxane unit. Examples of the alkylene group include the same groups as described above, and preferably an ethylene group or hexylene group.

M unit is a siloxane unit that configures a terminal of component (A₂), and D unit is a siloxane unit that configures a straight chain polysiloxane structure. Note that the alkenyl group is preferably on the M unit or D unit, particularly the M unit. On the other hand, the R³M unit and R³D unit are bonded to a silicon atom in a different siloxane unit through a silalkylene bond, and is a siloxane unit bonded to a silicon atom in a different siloxane unit through an oxygen atom. The T/Q unit is a branched siloxane unit that provides a resinous structure to the polysiloxane, and component (A₂) preferably contains siloxane units represented by R²SiO_{3/2} and/or siloxane units represented by SiO_{4/2}. In particular, component (A₂) preferably contains a siloxane unit represented by R²SiO_{3/2}, and particularly preferably contains a siloxane unit where R² is a phenyl group, because hot melt properties of component (A₂) are improved and the content of the aryl group in component (A₂) is adjusted.

The R³M/R³D unit is one of the characteristic structures of component (A₂), and expresses a structure where silicon atoms are crosslinked through the alkylene group of R³. Specifically, the R³M/R³D unit is at least one type of siloxane unit selected from a siloxane unit containing an alkylene group represented by R³_{1/2}R²₂SiO_{1/2} and siloxane unit containing an alkylene group represented by R³_{1/2}R²SiO_{2/2}, and at least two of all siloxane units that configure component (A₂) are preferably siloxane units containing an alkylene group. A preferable bonding form of R³ between siloxane units with an alkylene group is as described above, and the number of R³ between the two siloxane units containing an alkylene group is expressed as a valence of "1/2", similar to oxygen or the like in the M unit. If the number of R³ is 1, at least one or more selected from structural units of siloxane represented by [O_{1/2}R²₂SiR³SiR²₂O_{1/2}], [O_{1/2}R²₂SiR³SiR²O_{2/2}], and [O_{2/2}R²SiR³SiR²O_{2/2}] are contained in component (A₂), and the oxygen atom (O) is bonded to the silicon atom contained in M, D, T/Q units. By having this structure, component (A₂) can relatively easily be designed with a structure having a linear polysiloxane structure formed from the D unit and a resinous polysiloxane structure containing the T/Q unit in the molecule, and the physical properties thereof are remarkably excellent.

The aforementioned (1) can be achieved by hydrosilylation reaction of the organopolysiloxane having at least two alkenyl groups in a molecule and the organopolysiloxane having at least two silicon-bonded hydrogen atoms in a molecule, at a reaction ratio where [moles of alkenyl groups] / [moles of silicon-bonded hydrogen atoms] > 1.

The aforementioned (2) can be achieved by radical reaction of at least two types of organopolysiloxane having at least two radical reactive groups in a molecules, by using an amount of organic peroxide that is insufficient for all radical reactive groups in the system to react.

In the aforementioned (1) and (2), component (A₂) is a product of a hydrosilylation reaction or radical reaction of an organopolysiloxane having a resinous siloxane structure and an organopolysiloxane having a linear siloxane structure.

For example, component (A₂) is an organopolysiloxane obtained by reacting
(A^{R}) at least one type of resinous organopolysiloxane comprising in the molecular a siloxane unit represented by R²SiO_{3/2} (in the formula, R² is the same group as the aforementioned.) and/or a siloxane unit represneted by SiO_{4/2}, and having an alkenyl group with 2 to 20 carbon atoms, silicon-bonded hydrogen atom, or a radical reactive group; and
(A^{L}) at least one type of linear organopolysiloxane comprising in the molecule a siloxane unit represented by R²₂SiO_{2/2} (in the formula, R² is the same group as the aforementioned.), and having an alkenyl group with 2 to 20 carbon atoms or a silicon-bonded hydrogen atom, that is hydrosilylation reactive or radical reactive with the aforementioned component (A^{R}),
reacted at a ratio designed such that the hydrosilyl reactive group and/or radical reactive group in component (A^{R}) or component (A^{L}) remains even after the reaction.

In the aforementioned (1), if at least a portion of component (A^{R}) is a resinous organopolysiloxane having an alkenyl group with 2 to 20 carbon atoms, at least a portion of component (A^{L}) is preferably a linear organopolysiloxane having a silicon-bonded hydrogen atom.

Similarly, if at least a portion of component (A^{R}) is a resinous organopolysiloxane with a silicon-bonded hydrogen atom, at least a portion of component (A^{L}) is preferably a linear organopolysiloxane having an alkenyl group with 2 to 20 carbon atoms.

Component (A₂) is preferably
component (a₁): a product radically reacted by an organic peroxide with an organopolysiloxane with at least two alkenyl groups with 2 to 20 carbon atoms in the molecule, composed of component (a₁₋₁) and/or (a₁₋₂) described below, or a product hydrosilylationally reacted with component (a₁) and (a₂) an organohydrogenpolysiloxane, in an amount that the mol ratio of the silicon-bonded hydrogen atoms in the aforementioned component (a₂) is 0.2 to 0.7 mol with regard to the alkenyl groups with 2 to 20 carbon atoms contained in the aforementioned component (a₁) in the presence of a hydrosilylation reaction catalyst.

Component (a₁₋₁) is a polysiloxane with a relatively large amount of branched units, and is an organopolysiloxane having at least two alkenyl groups in a molecule and represented by the following average unit formula:

(R⁴₃SiO_{1/2})ₐ(R⁴₂SiO_{2/2})_{b}(R⁴SiO_{3/2})_{c}(SiO_{4/2})_{d}(R⁵O_{1/2})ₑ.

In the formula, each R⁴ is independently an alkyl group with 1 to 20 carbon atoms, halogen-substituted alkyl group with 1 to 20 carbon atoms, alkenyl group with 2 to 20 carbon atoms, aryl group with 6 to 20 carbon atoms, halogen-substituted aryl group with 6 to 20 carbon atoms, or aralkyl group with 7 to 20 carbon atoms, and examples include the same groups as the aforementioned R¹. R⁴ is preferably a methyl group, vinyl group, or phenyl group. However, at least two of R⁴ are alkenyl groups. Furthermore, preferably 10 mol% or higher or 20 mol% or higher of all of R⁴ are phenyl groups in order to achieve good hot melt properties. Furthermore, R⁵ in the formula is a hydrogen atom or an alkyl group with 1 to 6 carbon atoms, and examples include the same alkyl groups as described above.

Furthermore, in the formula, "a" is a number within a range of 0 to 0.7, "b" is a number within a range of 0 to 0.7, "c" is a number within a range of 0 to 0.9, "d" is a number within a range of 0 to 0.7, "e" is a number within a range of 0 to 0.1, and "c+d" is a number within a range of 0.3 to 0.9, and "a+b+c+d" is 1, and preferably, "a" is a number within a range of 0 to 0.6, "b" is a number within a range of 0 to 0.6, "c" is a number within a range of 0 to 0.9, "d" is a number within a range of 0 to 0.5, "e" is a number within a range of 0 to 0.05, and "c+d" is a number within a range of 0.4 to 0.9, and "a+b+c+d" is 1. This is because, if "a", "b", and "c+d" are numbers within the aforementioned range, the cured product that is obtained will have excellent hardness and mechanical strength.

The organopolysiloxanes below are examples of component (a₁₋₁). In the formulae, Me, Ph, and Vi each represent a methyl group, phenyl group, and vinyl group.

(ViMe₂SiO_{1/2})_{0.25}(PhSiO_{3/2})_{0.75}(HO_{1/2})_{0.02}

(ViMe₂SiO_{1/2})_{0.25}(PhSiO_{3/2})_{0.75}

(ViMe₂SiO_{1/2})_{0.20}(PhSiO_{3/2})_{0.80}

(ViMe₂SiO_{1/2})_{0.15}(Me₃SiO_{1/2})_{0.38}(SiO_{4/2})_{0.47}(HO_{1/2})_{0.01}

(ViMe₂SiO_{1/2})_{0.13}(Me₃SiO_{1/2})_{0.45}(SiO_{4/2})_{0.42}(HO_{1/2})_{0.01}

(ViMe₂SiO_{1/2})_{0.15}(PhSiO_{3/2})_{0.85}(HO_{1/2})_{0.01}

(Me₂SiO_{2/2})_{0.15}(MeViSiO_{2/2})_{0.10}(PhSiO_{3/2})_{0.75}(HO_{1/2})_{0.04}

(MeViPhSiO_{1/2})_{0.20}(PhSiO_{3/2})_{0.80}(HO_{1/2})_{0.05}

(ViMe₂SiO_{1/2})_{0.15}(PhSiO_{3/2})_{0.75}(SiO_{4/2})_{0.10}(HO_{1/2})_{0.02}

(Ph₂SiO_{2/2})₀.₂₅(MeViSiO_{2/2})₀.₃₀(PhSiO_{3/2})₀.₄₅(HO_{l/2})₀.₀₄

(Me₃SiO_{1/2})_{0.20}(ViMePhSiO_{1/2})_{0.40}(SiO_{4/2})_{0.40}(HO_{1/2})_{0.08}

Component (a₁₋₂) is a polysiloxane with a relatively large amount of linear siloxane units, and is an organopolysiloxane having at least two alkenyl groups with 2 to 20 carbon atoms in a molecule and represented by the following average unit formula:

(R⁴₃SiO_{1/2})_{a'} (R₄2SiO_{2/2})_{b'} (R⁴SiO_{3/2})_{c'} (SiO_{4/2})_{d'} (R⁵O_{1/2})_{e'}.

In the formula, R⁴ and R⁵ are the same groups as the aforementioned.

Furthermore, in the formula, "a'" is a number within a range of 0.01 to 0.3, "b'" is a number within a range of 0.4 to 0.99, "c'" is a number within a range of 0 to 0.2, "d'" is a number within a range of 0 to 0.2, "e'" is a number within a range of 0 to 0.1, and "c'+d'" is a number within a range of 0 to 0.2, and "a'+b'+c'+d'" is 1, and preferably, "a'" is a number within a range of 0.02 to 0.20, "b'" is a number within a range of 0.6 to 0.99, "c'" is a number within a range of 0 to 0.1, "d'" is a number within a range of 0 to 0.1, "j'" is a number within a range of 0 to 0.05, and "c'+d'" is a number within a range of 0 to 0.1, and "a'+b'+c'+d'" is 1. This is because, if "a'", "b'", "c'", and "d'" are numbers within the aforementioned range, the cured product that is obtained will have toughness.

The organopolysiloxanes below are examples of component (a₁₋₂). In the formulae, Me, Ph, and Vi each represent a methyl group, phenyl group, and vinyl group. ViMe₂SiO(MePhSiO)₁₈ SiMe₂Vi, in other words, (ViMe₂SiO_{1/2})_{0.10}(MePhSiO_{2/2})_{0.90} ViMe₂SiO(MePhSiO)₃₀ SiMe₂Vi, in other words, (ViMe₂SiO_{1/2})_{0.063}(MePhSiO_{2/2})_{0.937} ViMe₂SiO(MePhSiO)₁₅₀ SiMe₂Vi, in other words, (ViMe₂SiO_{1/2})_{0.013}(MePhSiO_{2/2})_{0.987} ViMe₂SiO(Me₂SiO)₁₈ SiMe₂Vi, in other words, (ViMe₂SiO_{1/2})_{0.10}(Me₂SiO_{2/2})_{0.90} ViMe₂SiO(Me₂SiO)₃₀ SiMe₂Vi, in other words, (ViMe₂SiO_{1/2})_{0.063}(Me₂SiO_{2/2})_{0.937} ViMe₂SiO(Me₂SiO)₃₅(MePhSiO)₁₃ SiMe₂Vi, in other words, (ViMe₂SiO_{1/2})_{0.04}(Me₂SiO_{2/2})_{0.70}(MePhSiO_{2/2})_{0.26} ViMe₂SiO(Me₂SiO)₁₀ SiMe₂Vi, in other words, (ViMe₂SiO_{1/2})_{0.17}(Me₂SiO_{2/2})_{0.83} (ViMe₂SiO_{1/2})_{0.10}(MePhSiO_{2/2})_{0.80}(PhSiO_{3/2})_{0.10}(HO_{1/2})_{0.02} (ViMe₂SiO_{1/2})_{0.20}(MePhSiO_{2/2})_{0.70}(SiO_{4/2})_{0.10}(HO_{1/2})_{0.01} HOMe₂SiO(MeViSiO)₂₀ SiMe₂OH Me₂ViSiO(MePhSiO)₃₀ SiMe₂Vi Me₂ViSiO(Me₂SiO)₁₅₀ SiMe₂Vi

Component (a₁₋₁) is preferably used in view of providing hardness and mechanical strength to the obtained cured product. Component (a₁₋₂) can be added as an optional ingredient in view of providing toughness to the obtained cured product, but this can be substituted by using a crosslinking agent that contains a large amount of linear siloxane units in component (a₂) below. In both cases, the mass ratio of the component having a large amount of branch siloxane units and the component having a large amount of linear siloxane units is preferably within a range of 50:50 to 100:0 or within a range of 60:40 to 100:0. This is because the hardness and mechanical strength of the obtained cured product will be favorable if the mass ratio of the component having a large amount of branch siloxane units and the component having a large amount of linear siloxane units is a value within the aforementioned range.

Note that if component (a₁) is radically reacted by organic peroxide, component (a₁₋₁) and component (a₁₋₂) are reacted in a range of 10:90 to 90:10, and component (a₂) is not required to be used.

Component (a₂) is a component for crosslinking component (a₁₋₁) and/or (a₁₋₂) in a hydrosilylation reaction, and is an organopolysiloxane containing at least two silicon-bonded hydrogen atoms in a molecule. Examples of the group bonded to a silicon atom other than hydrogen atoms in component (a₂) include an alkyl group with 1 to 20 carbon atoms, halogen-substituted alkyl group with 1 to 20 carbon atoms, aryl group with 6 to 20 carbon atoms, halogen-substitued aryl group with 6 to 20 carbon atoms, aralkyl group with 7 to 20 carbon atoms, alkoxy group, group containing an epoxy group, and hydroxyl group, and the same groups as the aforementioned.

Component (a₂) is not restricted, but preferably an organohydrogenpolysiloxane represented by the following average composition formula:

R⁶ₖHₘSiO_{(4-k-m)/2}.

In the formula, R⁶ is an alkyl group with 1 to 20 carbon atoms, halogen-substituted alkyl group with 1 to 20 carbon atoms, aryl group with 6 to 20 carbon atoms, halogen-substituted aryl group with 6 to 20 carbon atoms, or aralkyl group with 7 to 20 carbon atoms, and examples include the same groups as the aforementioned R¹, and preferably a methyl group or phenyl group.

Furthermore, in the formula, "k" is a number within a range of 1.0 to 2.5, preferably a number within a range of 1.2 to 2.3, "m" is a number within a range of 0.01 to 0.9, preferably a number within a range of 0.05 to 0.8, and "k+m" is a number within a range of 1.5 to 3.0, preferably a number within a range of 2.0 to 2.7.

Component (a₂) can be a resinous organohydrogenpolysiloxane having a large amount of branch siloxane units, or a linear organohydrogenpolysiloxane having a large amount of linear siloxane units. Specifically, examples of component (a₂) include an organohydrogenpolysiloxane represented by (a₂₋₁) below, organohydrogenpolysiloxane represented by (a₂₋₂) below, and a mixture thereof.

Component (a₂₋₁) is a resinous organohydrogenpolysiloxane having a silicon-bonded hydrogen atom and represented by the following average unit formula:

[R⁷₃SiO_{1/2}]_{f}[R⁷₂SiO_{2/2}]_{g}[R⁷SiO_{3/2}]ₕ[SiO_{4/2}]ᵢ(R⁵O_{1/2})ⱼ.

In the formula, each R⁷ is independently an alkyl group with 1 to 20 carbon atoms, halogen-substituted alkyl group with 1 to 20 carbon atoms, aryl group with 6 to 20 carbon atoms, halogen-substituted aryl group with 6 to 20 carbon atoms, or aralkyl group with 7 to 20 carbon atoms, or a hydrogen atom, and examples include the same groups as the aforementioned R¹. Furthermore, R⁵ in the formula is an alkyl group with 1 to 6 carbon atoms, and examples include the same groups as the aforementioned.

Furthermore, in the formula, "f" is a number within a range of 0 to 0.7, "g" is a number within a range of 0 to 0.7, "h" is a number within a range of 0 to 0.9, "i" is a number within a range of 0 to 0.7, "j" is a number within a range of 0 to 0.1, and "h+i" is a number within a range of 0.3 to 0.9, and "f+g+h+i" is 1, and preferably, "f" is a number within a range of 0 to 0.6, "g" is a number within a range of 0 to 0.6, "h" is a number within a range of 0 to 0.9, "i" is a number within a range of 0 to 0.5, "j" is a number within a range of 0 to 0.05, and "h+i" is a number within a range of 0.4 to 0.9, and "f+g+h+i" is 1.

Component (a₂₋₂) is an organopolysiloxane having ate least two silicon-bonded hydrogen atom in a molecule and represented by the gollowing average unit formula:

(R⁷₃SiO_{1/2})_{f'} (R⁷₂SiO_{2/2})_{g'} (R⁷SiO_{3/2})_{h'} (SiO_{4/2})_{i'} (R⁵O_{1/2})_{j'}.

In the formula, R⁷ and R⁵ are the same groups as the aforementioned.

Furthermore, in the formula, "f" is a number within a range of 0.01 to 0.3, "g'" is a number within a range of 0.4 to 0.99, "h'" is a number within a range of 0 to 0.2, "i'" is a number within a range of 0 to 0.2, "j'" is a number within a range of 0 to 0.1, and "h'+i'" is a number within a range of 0 to 0.2, and "f+g'+h'+i'" is 1, and preferably, "f" is a number within a range of 0.02 to 0.20, "g'" is a number within a range of 0.6 to 0.99, "h'" is a number within a range of 0 to 0.1, "i'" is a number within a range of 0 to 0.1, "j'" is a number within a range of 0 to 0.05, and "h'+i'" is a number within a range of 0 to 0.1, and "f+g'+h'+i'" is 1.

As described above, in component (a₂), the resinous organopolysiloxane having a large amount of branch siloxane units provides hardness and mechanical strength to the cured product, and the obtained organopolysiloxane having a large amount of linear siloxane units provides toughness to the cured product, and therefore, component (a₂₋₁) and (a₂₋₂) are preferably appropriately used as component (a₂). Specifically, if there is a small amount of branched siloxane units in component (a₁), component (a₂₋₁) is preferably mainly used as component (a₂), and if there is a small amount of linear siloxane units in component (a₁), component (a₂₋₂) is preferably mainly used. In component (a₂), the mass ratio of component (a₂₋₁) and component (a₂₋₂) is within a range of 50:50 to 100:0, or preferably within a range of 60:40 to 100:0.

The organopolysiloxanes below are examples of component (a₂). In the formulae, Me and Ph each represent a methyl group and phenyl group. Ph₂Si(OSiMe₂H)₂, in other words, Ph_{0.67}Me_{1.33}H_{0.67}SiO_{0.67} HMe₂SiO(Me₂SiO)₂₀ SiMe₂H, in other words, Me_{2.00}H _{0.09}SiO_{0.95} HMe₂SiO(Me₂SiO)₅₅ SiMe₂H, in other words, Me_{2.00}H_{0.04}SiO_{0.98} PhSi(OSiMe₂H)₃, in other words, Ph_{0.25}Me_{1.50}H_{0.75}SiO_{0.75} (HMe₂SiO_{1/2})_{0.6}(PhSiO_{3/2})_{0.4}, in other words, Ph_{0.40}Me_{1.20}H_{0.60}SiO_{0.90}

The added amount of component (a₂) is an amount wherein the molar ratio of the silicon-bonded hydrogen atoms in component (a₂) is 0.2 to 0.7 with regard to the alkenyl group in component (a₁), and is preferably an amount wherein the molar ratio is 0.3 to 0.6. This is because, if the added amount of component (a₂) is within the aforementioned range, the cured product that is obtained has good initial hardness and mechanical strength.

The organic peroxide used for radical reaction of component (a₁) is not restricted, and an organic peroxide exemplified by component (C) below can be used. When performing a radical reaction, component (a₁) is preferably a mixture where the mass ratio of component (a₁₋₁) and component (a₁₋₂) is within a range of 10:90 to 90:10. Note that the added amount of organic peroxide is not restricted, but is preferably within a range of 0.1 to 5 parts by mass, within a range of 0.2 to 3 parts by mass, or within a range of 0.2 to 1.5 parts by mass with regards to 100 parts by mass of component (a₁).

Furthermore, the hydrosilylation reaction catalyst used for hydrosilation reaction of component (a₁) and component (a₂) is not particularly restricted, and the hydrosilylation reaction catalyst exemplified by component (C) below can be used. Note that the added amount of the hydrosilylation reaction catalyst is preferably an amount within a range of 0.01 to 500 ppm, within a range of 0.01 to 100 ppm, or within a range of 0.01 to 50 pp, with regard to the total amount of component (a₁) and component (a₂), with platinum system metal atoms in the hydrosilylation reaction catalyst as the mass unit.

The aforementioned (3) is a product where component (a₃) below and component (a₄) below were condensation reacted using a condensation reaction catalyst.

Component (a₃) is a condensation reactive organopolysiloxane represented by the following average unit formula:

(R'₃SiO_{1/2})ₚ(R⁸₂SiO_{2/2})_{q}(R⁸SiO_{3/2})ᵣ(SiO_{4/2})ₛ(R⁹O_{1/2})ₜ.

In the formula, each R⁸ is independently an alkyl group with 1 to 20 carbon atoms, halogen-substituted alkyl group with 1 to 20 carbon atoms, alkenyl group with 2 to 20 carbon atoms, aryl group with 6 to 20 carbon atoms, halogen-substituted aryl group with 6 to 20 carbon atoms, or aralkyl group with 7 to 20 carbon atoms, and examples include the same groups as described above. Furthermore, R⁹ in the formula is a hydrogen atom, an alkyl group with 1 to 6 carbon atoms, or an acyl group with 2 to 5 carbon atoms, and examples include alkoxy groups such as methoxy groups, ethoxy groups, and the like; and acyloxy groups. Component (a₃) contains at least one silicon-bonded hydroxyl group, silicon-bonded alkoxy group, or silicon-bonded acyloxy group in a molecule. Furthermore, in a molecule, at least two of R⁸ are alkenyl groups, and preferably 10 mol% or higher or 20 mol% or higher of all of R⁸ are phenyl groups.

In the formula, "p" is a number within a range of 0 to 0.7, "q" is a number within a range of 0 to 0.7, "r" is a number within a range of 0 to 0.9, "s" is a number within a range of 0 to 0.7, "t" is a number within a range of 0.01 to 0.10, and "r+s" is a number within a range of 0.3 to 0.9, and "p+q+r+s" is 1, and preferably, "p" is a number within a range of 0 to 0.6, "q" is a number within a range of 0 to 0.6, "r" is a number within a range of 0 to 0.9, "s" is a number within a range of 0 to 0.5, "t" is a number within a range of 0.01 to 0.05, and "r+s" is a number within a range of 0.4 to 0.9. This is because, if "p", "q", and "r+s" are numbers within the aforementioned range, a silicone can be obtained that is flexible at 25°C, is non-liquid, has low surface tackiness, and has hot melt properties with sufficiently low melt viscosity at a high temperature.

Component (a₄) is a condensation reactive organopolysiloxane represented by the following average unit formula:

(R⁸₃SiO_{1/2})_{p'}(R⁸₂SiO_{2/2})_{q'}(R⁸SiO_{3/2})_{r'}(SiO_{4/2})_{s'}(R⁹O_{1/2})_{t'}.

In the formula, R⁸ and R⁹ are the same groups as the aforementioned. Component (a₄) contains at least one silicon-bonded hydroxyl group, silicon-bonded alkoxy group, or silicon-bonded acyloxy group in a molecule. Furthermore, in the formula, "p'" is a number within a range of 0.01 to 0.3, "q'" is a number within a range of 0.4 to 0.99, "r'" is a number within a range of 0 to 0.2, "s'" is a number within a range of 0 to 0.2, "t'" is a number within a range of 0 to 0.1, and "r'+s'" is a number within a range of 0 to 0.2, and "p'+q'+r'+s'" is 1, and preferably, "p'" is a number within a range of 0.02 to 0.20, "q'" is a number within a range of 0.6 to 0.99, "r'" is a number within a range of 0 to 0.1, "s'" is a number within a range of 0 to 0.1, "t'" is a number within a range of 0 to 0.05, and "r'+s'" is a number within a range of 0 to 0.1. This is because, if "p'", "q'", "r'", and "s'" are numbers within the aforementioned range, a silicone that is flexible at 25°C, is non-liquid, has low surface tackiness, and has hot melt properties with sufficiently low melt viscosity at a high temperature can be obtained.

The condensation reaction catalyst for condensation reaction of component (a₃) and component (a₄) is not restricted, and examples include organic tin compounds such as dibutyltin dilaurate, dibutyltin diacetate, tin octoate, dibutyltin dioctate, tin laurate, and the like; organic titanium compounds such as tetrabutyl titanate, tetrapropyl titanate, dibutoxybis (ethylacetoacetate), and the like; acidic compounds such as hydrochloric acid, sulfuric acid, dodecylbenzenesulfonic acid, and the like; alkaline compounds such as ammonia, sodium hydroxide, and the like; and amine compounds such as 1,8-diazabicyclo [5.4.0] undecene (DBU), 1,4-diazabicyclo [2.2.2] octane (DABCO), and the like; and preferably organic tin compounds and organic titanium compounds.

Furthermore, component (A₃) is a block copolymer formed from a resinous organosiloxane block and a linear organosiloxane block. Component (A₃) is preferably formed from a disiloxy unit of a formula [R¹₂SiO_{2/2}] of 40 to 90 mol%, and trisiloxy unit of a formula [R¹SiO_{3/2}] of 10 to 60 mol%, and preferably contains a silanol group [≡SiOH] of 0.5 to 35 mol%. Herein, each R¹ is independently an alkyl group with 1 to 20 carbon atoms, halogen-substituted alkyl group with 1 to 20 carbon atoms, alkenyl group with 2 to 20 carbon atoms, aryl group with 6 to 20 carbon atoms, halogen-substituted aryl group with 6 to 20 carbon atoms, or aralkyl group with 7 to 20 carbon atoms, and examples include the same groups as the aforementioned. In a molecule, at least two of R¹ are alkenyl groups. Furthermore, component (A₃) is a resinous organopolysiloxane block copolymer wherein the aforementioned disiloxy unit [R¹₂SiO_{2/2}] forms straight chain blocks having an average of 100 to 300 disiloxy units per straight chain block, the aforementioned trisiloxy unit [R¹SiO_{3/2}] forms non-straight chain blocks having a molecular weight of at least 500 g/mol, at least 30% of the non-straight chain blocks are mutually bonded, the straight chain blocks are bonded through at least one non-straight chain block and -Si-O-Si- bond and has a mass average molecular weight of at least 20000 g/mol, and at least one alkenyl group of 0.5 to 4.5 mol% is contained.

Component (A₃) is prepared by condensation reaction of (a₅) resinous organosiloxane or resinous organosiloxane block copolymer with (a₆) linear organosiloxane, and as required, (a₇) siloxane compound.

Component (a₅) is a condensation reactive organopolysiloxane represented by the following average unit formula:

[R¹₂R²SiO_{1/2}]ᵢ[R¹R²SiO_{2/2}]ᵢᵢ[R¹SiO_{3/2}]ᵢᵢᵢ[R²SiO_{3/2}]ᵢᵥ[SiO_{4/2}]ᵥ.

In the formula, each R¹ is independently an alkyl group with 1 to 20 carbon atoms, halogen-substituted alkyl group with 1 to 20 carbon atoms, alkenyl group with 2 to 20 carbon atoms, aryl group with 6 to 20 carbon atoms, halogen-substituted aryl group with 6 to 20 carbon atoms, or aralkyl group with 7 to 20 carbon atoms, and examples include the same groups as described above. Furthermore, in the formula, each R² is independently an alkyl group with 1 to 20 carbon atoms, halogen-substituted alkyl group with 1 to 20 carbon atoms, aryl group with 6 to 20 carbon atoms, halogen-substituted aryl group with 6 to 20 carbon atoms, or aralkyl group with 7 to 20 carbon atoms, and examples include the same groups as the aforementioned R¹.

Furthermore, in the formula, "i", "ii", "iii", "iv", and "v" represent the mole fraction of the siloxy units, and "i" is a number from 0 to 0.6, "ii" is a number from 0 to 0.6, "iii" is a number from 0 to 1, "iv" is a number from 0 to 1, and "v" is a number from 0 to 0.6, and "ii+iii+iv+v" > 0, and "i+ii+iii+iv+v" ≤ 1. Furthermore, component (a₅) preferably contains 0 to 35 mol% of a silanol group [=SiOH] in a molecule.

Component (a₆) is a straight chain organosiloxane represented by the following general formula:

R'_{3-α}(X)_{α}SiO(R¹₂SiO)_{β}Si(X)_{α}R¹_{3-α}.

In the formula, R¹ is the same as the aforementioned, and examples include the same groups as the aforementioned. Furthermore, in the formula, X is a hydrolysable group selected from -OR⁵, F, Cl, Br, I, -OC (O) R⁵, -N(R⁵)₂, or -ON=CR⁵₂ (herein, R⁵ is a hydrogen atom or an alkyl group with 1 to 6 carbon atoms.) Furthermore, in the formula, each "α" is independently 1, 2, or 3, and "β" is an integer of 50 to 300.

Component (a₇) is a siloxane compound represented by the following general formula:

R¹R²SiX.

In the formula, R¹, R², and X are the same groups as described above.

The condensation reaction catalyst for condensation reaction of component (a₅), component (a₆), and/or component (a₇) is not restricted, and examples include organic tin compounds such as dibutyltin dilaurate, dibutyltin diacetate, tin octoate, dibutyltin dioctate, tin laurate, and the like; organic titanium compounds such as tetrabutyl titanate, tetrapropyl titanate, dibutoxybis (ethylacetoacetate), and the like; acidic compounds such as hydrochloric acid, sulfuric acid, dodecylbenzenesulfonic acid, and the like; alkaline compounds such as ammonia, sodium hydroxide, and the like; and amine compounds such as 1,8-diazabicyclo [5.4.0] undecene (DBU), 1,4-diazabicyclo [2.2.2] octane (DABCO), and the like.

Component (A) preferably exhibits hot melt properties, is specifically non-liquid at 25°C, and has a melt viscosity at 100°C of preferably 8000 Pa·s. Non-liquid refers to not flowing at an unloaded condition, and refers to a condition that is lower than the softening point measured by a softening point testing method of a hot melt adhesive by a ball and ring method specified in JIS K 6863-1994 "Softening point testing method of a hot melt adhesive". In other words, the softening point is required to be higher than 25°C in order to be non-liquid at 25°C.

Component (A) has a melt viscosity at 100°C of preferably 8000 Pa·s or lower, 5000 Pa·s or lower, or within a range of 10 to 3000 Pa·s. If the melt viscosity at 100°C is within the aforementioned range, adhesion of component (A) is good after cooling to 25°C after hot melting is performed.

As long as component (A) is in the form of fine particles, particle size is not restricted, but the average primary particle size is preferably within a range 1 to 5000 µm, within a range of 1 to 500 µm, within a range of 1 to 100 µm, within a range of 1 to 20 µm, or within a range of 1 to 10 µm. The average primary particle size can be obtained by observing with a light microscope or SEM. The form of component (A) is not restricted, and examples thereof include a spherical shape, spindle shape, plate shape, needle shape, and indefinite shape, but is preferably a spherical shape in order to achieve uniformly melting.

The method of manufacturing component (A) is not restricted, and a known method can be used. Examples include a method of simply forming component (A) into fine particles, or a method of simultaneously or individually performing a step of crosslinking at least two types of organopolysiloxanes and a step of forming the reaction product thereof into fine particles.

After crosslinking at least two types of organopolysiloxanes, examples of forming the obtained silicone into fine particles include a method of pulverizing the silicone using a pulverizer or a method of directly forming the silicone into fine particles in the presence of a solvent, for example. The pulverizer is not restricted, but examples of the pulverizer include a roller mill, ball mill, jet mill, turbo mill, and planetary mill. Furthermore, examples of a method of directly forming the silicone into fine particles in the presence of a solvent, include spraying by a spray dryer or forming into fine particles by a biaxial kneader or a belt dryer.

Component (A) having a spherical shape and an average primary particle size of 1 to 500 µm can be manufactured by the use of a spray dryer or the like. Note that a heating/drying temperature of the spray dryer is required to be set appropriately based on the heat resistance or the like of the silicone fine particles. Note that the temperature of the silicone fine particles is preferably controlled to a glass transition temperature thereof or lower in order to prevent secondary aggregation of the silicone fine particles. The silicone fine particles thus obtained can be recovered using a cyclone, bag filter, or the like.

A solvent may be used within a range that does not inhibit the curing reaction in the aforementioned steps, with the purpose of obtaining a uniform component (A). The solvent is not restricted, but examples include aliphatic hydrocarbons such as n-hexane, cyclohexane, n-heptane, and the like; aromatic hydrocarbons such as toluene, xylene, mesitylene, and the like; ethers such as tetrahydrofuran, dipropyl ether, and the like; silicones such as hexamethyldisiloxane, octamethyltrisiloxane, decamethyltetrasiloxane, and the like; esters such as ethyl acetate, butyl acetate, propylene glycol monomethyl ether actetate and the like; and ketones such as acetone, methyl ethyl ketone, methyl isobutyl ketone, and the like.

Component (B) is at least one type of filler that does not have a softening point or does not soften at the softening point of component (A) or lower, and is a component that improves handling workability of the present composition and provides mechanical properties or other properties to the cured product of the present composition. Examples of component (B) include inorganic fillers, organic fillers, and mixtures thereof, but preferably an inorganic filler. Examples of the inorganic filler include reinforcing fillers, white pigments, heat conductive fillers, electrically conductive fillers, phosphors, and mixtures of two types or more thereof. Furthermore, examples of the organic filler include silicone resin type fillers, fluororesin type fillers, and polybutadiene resin type fillers.

When using the present composition in a sealing agent, protective agent, adhesive, or the like, component (B) is preferably a reinforcing filler in order to provide mechanical strength to the cured product and improve protective properties and adhesion. Examples of the reinforcing filler include a fumed silica, precipitated silica, fused silica, calcined silica, fumed titanium dioxide, quartz, calcium carbonate, diatomaceous earth, aluminum oxide, aluminum hydroxide, zinc oxide, and zinc carbonate. Furthermore, a surface of the reinforcing fillers can be treated by organoalkoxysilanes such as methyltrimethoxysilane or the like; organohalosilanes such as trimethylchlorosilane and the like; organosilazanes such as hexamethyldisilazane and the like; siloxane oligomers or the like such as α,ω-silanol groups-terminated dimethylsiloxane oligomer, α,ω-silanol groups-terminated methylphenylsiloxane oligomer, α,ω-silanol groups-terminated methylvinylsiloxane oligomer, and the like. The particle size of the reinforcing filler is not restricted, but the median diameter measured by a laser diffraction scattering type particle size distribution measurement is preferably within a range of 1 nm to 500 µm. Furthermore, fibrous fillers such as a calcium metasilicate, potassium titanate, magnesium sulfate, sepiolite, sonolite, aluminum borate, rock wool, glass fiber, and the like can be used as the reinforcing filler.

Furthermore, when using the present composition in a light reflecting material for LED, component (B) is preferably a white pigment in order to provide a degree of whiteness to the cured product. Examples of the white pigment include metal oxides such as titanium oxide, aluminum oxide, zinc oxide, zirconium oxide, magnesium oxide, and the like; hollow fillers such as glass balloons, glass beads, and the like; and other barium sulfate, zinc sulfate, barium titanate, aluminum nitride, boron nitride, and antimony oxide. Titanium oxide has high optical reflectivity and concealing properties, and is therefore preferable. Furthermore, aluminum oxide, zinc oxide, and barium titanate have high optical reflectivity of a UV region, and are therefore preferable. The average particle size or shape of the white pigment is not restricted, but the average particle size is within a range of 0.05 to 10.0 µm and preferably within a range of 0.1 to 5.0 µm. Furthermore, a surface of the white pigment can be treated by a silane coupling agent, silica, aluminum oxide, and the like.

Furthermore, when using the present composition in a wavelength conversion material for LED, component (B) is preferably a phosphor in order to convert the emission wavelength from an optical semiconductor device. Examples of the phosphor include yellow, red, green, and blue light emitting phosphor formed from oxide-based phosphor, oxynitride-based phosphor, nitride-based phosphor, sulfide-based phosphor, oxysulfide-based phosphor, or the like widely used in a light emitting diode (LED). Examples of the oxide-based phosphor include YAG type green to yellow light emitting phosphors of yttrium, aluminum, and garnet containing cerium ions; TAG type yellow light emitting phosphors of terbium, aluminum, and garnet containing cerium ions; and silicate type green to yellow light emitting phosphors containing cerium or europium ions. Furthermore, examples of the oxynitride-based phosphor include sialon type red to green light emitting phosphorsof silicon, aluminum, oxygen, and nitrogen containing europium ions. Examples of nitride-based phosphors include calcium, strontium, aluminum, silicon, and nitrogen-type CASN red light-emitting phosphors containing europium ions. Examples of sulfide-based phosphors include ZnS green light-emitting phosphors containing copper ions or aluminum ions. Examples of oxysulfide-based phosphors include Y₂O₂S red light-emitting phosphors containing europium ions. In the present composition, two types or more of the phosphors can be used in combination.

Furthermore, the present composition can contain a heat conductive filler or an electrically conductive filler in order to provide heat conductivity or electrical conductivity to the cured product. Examples of the heat conductive filler or the conductive filler include metal powders such as gold, silver, nickel, copper, aluminum, and the like; fine powders such as ceramic, glass, quartz, organic resin, and the like wherein the powder surface thereof is deposited or plated by metals such as gold, silver, nickel, copper, and the like; metal compounds such as aluminum oxide, magnesium oxide, aluminum nitride, boron nitride, zinc oxide, and the like; graphite, and a mixture of two types or more thereof. When electrical insulating properties are required for the present composition, metal oxide powder or metal nitride powder is preferable, and aluminum oxide powder, zinc oxide powder, or aluminum nitride powder is particularly preferable.

The amount of component (B) is not restricted, but the amount is preferably within a range of 10 to 3000 parts by mass, within a range of 10 to 2500 parts by mass, or within a range of 10 to 2000 parts by mass with regards to 100 parts by mass of component (A) in order for the obtained cured product to have excellent hardness and mechanical strength.

Component (C) is a curing agent to cure component (A), and is not restricted as long as component (C) can cure component (A). If component (A) contains an alkenyl group, component (C) is an organohydrogenpolysiloxane having at least two silicon-bonded hydrogen atoms in a molecule and a hydrosilylation reaction catalyst, and if component (A) contains an alkenyl group and contains a hydrosilylation reaction catalyst, component (C) can be only an organopolysiloxane having at least two silicon-bonded hydrogen atoms in a molecule, or can be used in combination with a hydrosilylation reaction catalyst. Furthermore, if component (A) contains an alkenyl group, component (C) can be an organic peroxide, and can be used in combination with an organopolysiloxane having at least two silicon-bonded hydrogen atoms in a molecule. On the other hand, if component (A) contains a silicon-bonded hydrogen atom, component (C) is an organohydrogenpolysiloxane having at least two alkenyl groups in a molecule and a hydrosilylation reaction catalyst, and if component (A) contains a silicon-bonded hydrogen atom and contains a hydrosilylation reaction catalyst, component (C) can be only an organopolysiloxane having at least two alkenyl groups in a molecule, or can be used in combination with a hydrosilylation reaction catalyst.

Examples of the organopolysiloxane in component (C) include the organopolysiloxane containing an alkenyl group that is represented by the aforementioned (a₁) and/or the aforementioned (a₂), or the organopolysiloxane containing a silicon-bonded hydrogen atom that is represented by the aforementioned (a₃) and/or the aforementioned (a₄).

If an organopolysiloxane is used as component (C), the amount thereof is not restricted, but in order for the present composition to be cured, the amount of silicon-bonded hydrogen atoms is within a range of 0.5 to 20 mol and preferably within a range of 1.0 to 10 mol with regards to 1 mol of alkenyl groups in the present composition.

Examples of the hydrosilylation reaction catalyst include a platinum-based catalyst, a rhodium-based catalyst, and a palladium-based catalyst, but preferably a platinum-based catalyst in order to greatly accelerate the curing of the present composition. Examples of the platinum-based catalyst include catalysts wherein platinum fine powder, chloroplatinic acid, alcohol solution of chloroplatanic acid, platinum-alkenylsiloxane complex, platinum-olefin complex, platinum-carbonyl complex, and platinum-based catalysts thereof are dispersed or encapsulated by a thermoplastic resin such as silicone resin, polycarbonate resin, acrylic resin, or the like, but a particularly preferably a platinum-alkenylsiloxane complex. Examples of the alkenylsiloxane include 1,3-divinyl-1,1,3,3-tetramethyldisiloxane, 1,3,5,7-tetramethyl-1,3,5,7-tetravinylcyclotetrasiloxane, alkenylsiloxane wherein a portion of the methyl group of these alkenylpolysiloxanes are substituted by an ethyl group, phenyl group, or the like, and alkenylsiloxane wherein the vinyl group is substituted by an allyl group, hexenyl group, or the like. Particularly, 1,3-divinyl-1,1,3,3-tetramethyldisiloxane is preferable because of having good stability of the platinum-alkenylsiloxane complex.

The added amount of the hydrosilylation reaction catalyst is preferably an amount within a range of 0.01 to 500 ppm, an amount within a range of 0.01 to 100 ppm, or an amount within a range of 0.01 to 50 ppm.

Examples of the organic peroxide include alkyl peroxides, diacyl peroxides, peroxide esters, and peroxide carbonates.

Examples of the alkyl peroxides include dicumyl peroxide, di-tert-butyl peroxide, di-tert-butyl cumyl peroxide, 2,5-dimethyl-2,5-di (tert-butylperoxy) hexane, 2,5-dimethyl-2,5-di (tert-butylperoxy) hexyne-3, tert-butylcumyl, 1,3-bis (tert-butylperoxyisopropyl) benzene, and 3,6,9-triethyl-3,6,9-trimethyl-1,4,7-triperoxonane.

Examples of the diacyl peroxides include benzoyl peroxide, lauroyl peroxide, and decanoyl peroxide.

Examples of the peroxide esters include 1,1,3,3-tetramethylbutyl peroxyneodecanoate, α-cumyl peroxyneodecanoate, tert-butyl peroxyneodecanoate, tert-butyl peroxyneoheptanoate, tert-butyl peroxypivalate, tert-hexyl peroxypivalate, 1,1,3,3-tetramethylbutylperoxy-2-ethylhexanoate, tert-amyl peroxyl-2-ethyl hexanoate, tert-butyl peroxy-2-ethyl hexanoate, tert-butyl peroxy isobutylate, di-tert-butyl peroxy hexahydroterephthalate, tert-amyl peroxy-3,5,5-trimethylhexanoate, tert-butylperoxy-3,5,5-trimethylhexanoate, tert-butylperoxyacetate, tert-butylperoxybenzoate, and di-butyl peroxy trimethyl adipate.

Examples of the peroxide carbonates include di-3-methoxybutyl peroxydicarbonate, di (2-ethylhexyl) peroxydicarbonate, diisopropyl peroxycarbonate, tert-butyl peroxyisopropyl carbonate, di (4-tert-butylcyclohexyl) peroxydicarbonate, dicetyl peroxydicarbonate, and dimyristyl peroxydicarbonate.

The organic peroxides have a 10-hour half-life temperature of 90°C or higher, and preferably 95°C or higher. Examples of the organic peroxides include dicumyl peroxide, di-t-butyl peroxide, di-t-hexyl peroxide, t-butyl cumyl peroxide, 2,5-dimethyl-2,5-di (tert-butylperoxy) hexane, 1,3-bis (tert-butylperoxyisopropyl) benzene, di- (2-t-butylperoxyisopropyl) benzene, and 3,6,9-triethyl-3,6,9-trimethyl-1,4,7-triperoxonane.

The amount of organic peroxide is not restricted, but is preferably within a range of 0.05 to 10 parts by mass and within a range of 0.10 to 5.0 parts by mass with regards to 100 parts by mass of component (A).

Furthermore, the present composition can contain a curing retardant or an adhesion promoter as an optional component as long as the object of the present invention is not impaired.

Examples of the curing retardant include alkyne alcohols such as 2-methyl-3-butyn-2-ol, 3,5-dimethyl-1-hexyn-3-ol, 2-phenyl-3-butyn-2-ol, 1-ethynyl-1-cyclohexanol, and the like; en-yne compounds such as 3-methyl-3-penten-1-yne, 3,5-dimethyl-3-hexen-1-yne, and the like; low molecular weight siloxanes containing an alkenyl group such as tetramethyltetravinylcyclotetrasiloxane, tetramethyltetrahexenylcyclotetrasiloxane, and the like; and alkynyloxysilanes such as methyl-tris (1,1-dimethylpropynyloxy) silane, vinyl-tris (1,1-dimethylpropynyloxy) silane, and the like. The amount of the curing retardant is not restricted, but is preferably within a range of 10 to 10000 ppm in mass units with regards to the present composition.

Preferred adhesion promoters are organosilicon compounds having at least one alkoxy group bonded to a silicon atom in a molecule. This alkoxy group is exemplified by a methoxy group, an ethoxy group, a propoxy group, a butoxy group, and a methoxyethoxy group; and the methoxy group is particularly preferred. Furthermore, examples of the group bonded to the silicon atoms other than the alkoxy group in the organosilicon compound include halogen-substituted or unsubstituted monovalent hydrocarbon groups such as an alkyl group, alkenyl group, aryl group, aralkyl group, halogenated alkyl group, and the like; glycidoxyalkyl groups such as 3-glycidoxypropyl group, 4-glycidoxybutyl group, and the like; epoxycyclohexylalkyl groups such as 2-(3,4-epoxycyclohexyl) ethyl group, 3-(3,4-epoxycyclohexyl) propyl group, and the like; epoxyalkyl groups such as 3,4-epoxybutyl group, 7,8-epoxyoctyl group, and the like; monovalent organic groups containing an acryl group such as 3-methacryloxypropyl group, or the like; and hydrogen atoms. The organosilicon compound preferably has a group that can react with an alkenyl group or silicon atom-bonded hydrogen atom in the present composition. Specifically, the organosilicon compound preferably has a silicon atom-bonded hydrogen atom or alkenyl group. Moreover, due to the ability to impart good adhesion with respect to various types of substrates, this organosilicon compound preferably has at least one epoxy group-containing monovalent organic group in a molecule. Examples of the organosilicon compound include organosilane compounds, organosiloxane oligomers, and alkyl silicate. Examples of the molecular structure of the organosiloxane oligomer or alkyl silicate include a straight structure, partially branched straight structure, branched chain structure, ring-shaped structure, and net-shaped structure. A straight chain structure, branched chain structure, and net-shaped structure are particularly preferred. Examples of the organosilicon compound include silane compounds such as 3-glycidoxypropyltrimethoxysilane, 2-(3,4-epoxycyclohexyl) ethyltrimethoxysilane, 3-methacryloxypropyltrimethoxysilane, and the like; siloxane compounds having at least one of each of silicon-bonded alkenyl groups, silicon-bonded hydrogen atoms, and silicon-bonded alkoxy groups in one molecule; a mixture of a silane compound or siloxane compound having at least one silicon-bonded alkoxy group with a siloxane compound having at least one of each of silicon-bonded hydroxy group and silicon-bonded alkenyl group in one molecule; methyl polysilicate; ethyl polysilicate; and ethyl polysilicate containing an epoxy group. The adhesion promoter is preferably in a low-viscosity liquid form, and the viscosity is not restricted, but is preferably within a range of 1 to 500 mPa·s at 25°C. Furthermore, the amount of the adhesion promoter is not restricted, but is preferably within a range of 0.01 to 10 parts by mass with regards to a total of 100 parts by mass of the present composition.

Furthermore, as long as the object of the present invention is not impaired, the present composition can contain other optional components such as liquid organopolysiloxane of at least one type of the aforementioned (a1) through (a4); heat resistant agents such as iron oxide (red iron oxide), cerium oxide, cerium dimethylsilanolate, fatt acid cerium salt, cerium hydroxide, zirconium compound, and the like; mold release agents such as carnauba wax, montan wax, calcium stearate, calcium montanate, magnesium stearate, magnesium montanate, zinc stearate, zinc montanate, ester wax, olefin wax, and the like; and other dyes, pigments other than white, flame retardant, and the like.

The present composition can be used in a pellet form. The pellet of the present composition can be obtained by tablet compression of the present composition, and has excellent handling workability and curability. Note that "pellet" may also be referred to as "tablet". The shape of the pellet is not restricted, but is usually spherical, oval spherical, or cylindrical. Furthermore, the size of the pellet is not restricted, but has an average particle size more or has a circle equivalent diameter of 500 µm, for example.

The present composition is non-liquid at 25°C. Herein, non-liquid refers to not deforming or flowing at an unloaded condition, and preferably not deforming or flowing at 25°C and at an unloaded condition if the shape is molded into a pellet, tablet, or the like. The non-liquid properties can be evaluated by substantially not deforming or flowing even when placing the molded present composition onto a hot plate at 25°C and in an unloaded condition, or while applying a constant load, for example. This is because if the composition is non-liquid at 25°C, shape retention at the temperature is favorable and surface tackiness is low.

The softening point of the present composition preferably is 100°C or lower. The softening point refers to the temperature when the composition on the hot plate is continually pressed from above for 10 seconds by a load weighing 100 grams, and when the load is removed, the deformation amount in the height direction is 1 mm or more.

The present composition has a melt viscosity at 100°C of preferably 8000 Pa·s or lower, 6000 Pa·s or lower, or 5000 Pa·s or lower. Furthermore, the melt viscosity at 100°C is preferably 10 Pa·s or higher. This is because, after hot melting the present composition, adhesion to a substrate after cooling to 25°C is favorable. Note that the melt viscosity can be measured by a rheometer AR 2000 EX (manufactured by TA Instruments Japan Inc.) or the like.

The present composition has excellent curing characteristics. The curing characteristics of the present composition can be evaluated by using a rheometer. The curing characteristics of the present composition can be evaluated based on values T₁ and T₉₀, where if a torque value is 100 after three minutes at a constant temperature of 150 to 180°C, the time (seconds) required to obtain a 1% torque value and a 90% torque value are each T₁ and T₉₀. In the present composition, T₁ when measured at a constant temperature of 150 to 180°C is 20 seconds or more, and preferably 25 seconds or more. Furthermore, T₉₀ when measured at 150 to 180°C is 145 seconds or less, and preferably 140 seconds or less. Note that an example of the rheometer used for measurement is rheometer MDR 2000 (manufactured by Alpha Technologies, Ltd.)

### [Manufacturing method of the curable granular silicone composition]

The present composition can be manufactured by powder mixing component (A) through (C) and other optional components at a temperature under the softening point of component (A). The powder mixer used in the present manufacturing method is not restricted, and examples thereof include a single-screw or double-screw continuous mixer, two-roller mill, Ross mixer, Hobart mixer, dental mixer, planetary mixer, kneader mixer, laboratory mill, and Henschel mixer, but preferably a laboratory mill or Henschel mixer is used.

### [Method of molding the cured product]

The present composition can be cured by a method comprising the following steps (I) through (III).
(I) a step of heating and melting the present composition at a temperature higher than the softening point of component (A);
(II) a step of injecting the curable silicone composition obtained in step (I) into a metal mold; and
(III) a step of curing the curable silicone composition injected in step (II).

In the steps, a transfer molding machine, compression molding machine, injection molding machine, auxiliary ram type molding machine, slide type molding machine, double ram type molding machine, molding machine for low pressure sealing, or the like can be used.

Finally, in step (III), the curable silicone composition injected in step (II) is cured. Note that if an organic peroxide is used as component (C), the heating temperature is 150°C or higher, and preferably 170°C or higher.

The type D durometer hardness at 25°C of the cured product obtained by curing the present composition is preferably 60 or higher, and preferably 70 or higher from the perspective of being preferable as a protective member of a semiconductor or the like. Note that the type D durometer hardness is obtained by a type D durometer according to JIS K 6253-1997 "Hardness testing method of vulcanized rubber and thermoplastic rubber."

Furthermore, the bending strength of the cured product measured by a method specified in JIS K 6911-1995 "General testing method for thermosetting plastics" is 15 MPa or higher and preferably 20 MPa or higher from the perspective of being preferable as a sealing material for semiconductors which are required to have high hardness and high strength.

### EXAMPLES

The curable granular silicone composition of the present invention and the manufacturing method thereof are described in detail using Practical Examples and Comparative Examples. Note that, in the formulae, Me, Ph, Vi each represent a methyl group, phenyl group, and vinyl group. Furthermore, softening point, melt viscosity, curability, moldability, hardness of the cured product, bending strength, total luminous reflectance, and heat conductivity were measured in the following manner.

### [Softening point of the hot meltable silicone]

The hot meltable silicone was placed on a hot plate set at 25°C to 100°C, a spatula was used to confirm the condition thereof, and the liquefaction temperature was taken as the softening point.

### [Softening point of the curable granular silicone composition]

The curable granular silicone composition was molded into a columnar pellet of ϕ 14 mm x 22 mm. The pellet was placed on a hot plate set at 25°C to 100°C and continually pressed from above for 10 seconds by a load weighing 100 grams, the load was removed, and then the deformation of the pellet was measured. The temperature when the deformation in the height direction was 1 mm or more was taken as the softening point.

### [Melt viscosity]

Melt viscosity at 100°C of the hot meltable silicone and curable granular silicone composition was measured at a shear rate of 5 (1/s) using a rheometer AR 2000 EX (manufactured by TA Instruments Japan Inc.).

### [Curability]

Curability of the curable granular silicone composition was evaluated using a rheometer MDR 2000 (manufactured by Alpha Technologies, Ltd.). The curing temperature was 150°C in Examples 1 to 4, 7, and Comparative Example 2, and 180°C in Examples 5, 6, and Comparative Example 1. For the measurement, when the torque value three minutes after measurement was 100%, the time (seconds) taken to obtain 1% torque value was indicated by T₁, and the time (seconds) taken to obtain 90% torque value was indicated by T₉₀.

### [Moldability]

The curable granular silicone composition was cast with a copper lead frame using a transfer molding machine to prepare a molded product with a length of 35 mm, width of 25 mm, and height of 1 mm. In Examples 1 to 4, 7, and Comparative Examples 1 and 2, the molding conditions were a mold temperature of 150°C and clamping time of 120 seconds, and for Examples 5 and 6, a mold temperature of 180°C and clamping time of 120 seconds were used. The molded product was removed from the metal mold, cooled to 25°C, and then molding defects such as the presence or absence of cracks, peeling from the lead frame, and the like were visually inspected.

### [Hardness of Cured Product]

The curable granular silicone composition was heated at 150°C for two hours to prepare a cured product. The hardness of the cured product was measured by a type D durometer specified in JIS K 7215-1986 "Durometer hardness testing method for plastics."

### [Bending strength of the cured product]

The curable granular silicone composition was heated at 150°C for two hours to prepare a cured product. The bending strength of the cured product was measured by a method specified in JIS K 6911-1955 "General testing method for thermosetting plastics."

### [Total luminous reflectance of the cured product]

The curable granular silicone composition was heated at 150°C for two hours to prepare a cured product. The total luminous reflectance of the cured product was measured by a method specified in JIS K 7375:2008 "Determining the total luminous transmittance and total luminous reflectance of plastics."

### [Heat conductivity of the cured product]

The curable granular silicone composition was heated at 150°C for two hours to prepare a cured product. The heat conductivity of the cured product was measured using a Quick Thermal Conductivity Meter QTM-500 (manufactured by Kyoto Electronics Manufacturing Co., Ltd.).

### [Reference Example 1]

In a 1 L flask, 270.5 g of 55 mass% toluene solution of resinous organopolysiloxane in a white solid form at 25°C and represented by the following average unit formula:

(PhSiO_{3/2})_{0.80} (Me₂ViSiO_{1/2})_{0.20},

21.3 g (an amount where the silicon-bonded hydrogen atoms in the present component is 0.5 mol with regards to 1 mol of vinyl groups in the aforementioned resin organopolysiloxane) of diphenylsiloxane capped at both molecular terminals with dimethylhydrogensiloxy groups (silicon-bonded hydrogen atom content = 0.6 mass%), having a viscosity of 5 mPa·s and represented by the following formula: HMe₂SiO(Ph₂SiO)SiMe₂H,
and 0.034 g (amount where platinum metal is 10 ppm by mass unit with regard to the liquid mixture) of 1,3-divinyltetramethyldisiloxane solution of platinum 1,3-divinyltetramethyldisiloxane complex (content of platinum metal = approximately 4000 ppm) were introduced and uniformly stirred at room temperature. Then, the temperature in the flask was increased to 100°C using an oil bath and stirred for 2 hours under a toluene reflux to prepare a toluene solution of a crosslinked organosiloxane (1) having a vinyl group that was not involved in the aforementioned reaction, and formed from a resinous organosiloxane derived from the aforementioned resinous organopolysiloxane and a linear organosiloxane derived from the aforementioned diphenylsiloxane. Note that when the crosslinked organosiloxane (1) was analyzed by FT-IR, the peak of the silicon-bonded hydrogen atom was not observed. Furthermore, the softening point of the crosslinked organosiloxane (1) was 75°C, and the melt viscosity at 100°C was 700 Pa·s.

### [Reference Example 2]

318.6 g of 56.5 mass% toluene solution of an organopolysiloxane represented by the following average unit formula:

(PhSiO_{3/2})ₙ

(in the formula, "n" is a positive number such that the weight average molecular weight of the present organopolysiloxane is 1500.)
was introduced under a nitrogen atmosphere into a 500 mL, four-necked round bottom flask, connected to a thermometer, stirring blade made of Teflon (registered trademark), and a water cooling condensor, and provided with a Dean-Stark device previously filed with toluene. Heating was performed for 30 minutes at the reflux temperature of toluene, and 0.54 g of water was removed. Next, cooling to 108°C was performed, and 224.24 g of a methylphenyl polysiloxane mixture wherein 4.24 g (0.0187 mol) of a mixture of methyltriacetoxysilane/ethyltriacetoxysilane with a mol ratio of 1:1 and 220 g (1.614 mol) of methylphenylpolysiloxane capped at both molecular chain terminals with silanol groups (polymerization degree = 181) that were previously reacted for an hour at room temperature, was added. The reaction mixture was heated for 2 hours in a nitrogen atmosphere at the reflux temperature of toluene, and 2.01 g of water was further removed. Then, the reaction solution was cooled again to 108°C, 11.91 g (0.0633 mol) of vinylmethyldiacetoxysilane was added, heating was performed for 1 hour at the reflux temperature of toluene, and 1.05 g of water was removed. The reaction mixture was cooled to 90°C, 47.8 g of deionized water was added, and then water was removed by azeotropic distillation. The reaction solution was again cooled to 108°C, 21.57 g (0.0949 mol) of a mixture of
methyltriacetoxysilane/ethyltriacetoxysilane with a mol ratio of 1:1 was added, refluxing was performed for 1 hour, and then the reaction mixture was cooled to 90°C, 47.8 g of deionized water was added, and further refluxing was performed and water was removed by azeotropic distillation (the procedure of adding and removing water was repeated twice). The same treatment with water was repeated three times, and then finally 103.6 of volatile content was removed by distillation at 118°C, and the solid content of the reaction solution was adjusted to approximately 70 mass%. The obtained product was discovered to be an organosiloxane block copolymer formed from a resinous organosiloxane block and a straight chain organosiloxane block containing 2 mol% of vinyl groups. Furthermore, the softening point of the organosiloxane block copolymer (2) was 85°C, and the melt viscosity at 100°C was 2800 Pa·s.

Next, 292 g of the solution with solid content concentration of 50 mass% of the organosiloxane block copolymer was added with 0.034 g (amount where platinum metal is 10 ppm by mass unit with regard to the liquid mixture) of 1,3-divinyltetramethyldisiloxane solution of 1,3-divinyltetramethyldisiloxane complex of platinum (content of platinum metal = approximately 4000 ppm), uniformly stirred at room temperature (25°C), and prepared a toluene solution of the organosiloxane block copolymer (2) containing a platinum catalyst.

### [Reference Example 3]

In a 1 L flask, 270.5 g of 55 mass% toluene solution of resinous organopolysiloxane in a white solid form at 25°C and represented by the following average unit formula:

(PhSiO_{3/2})_{0.80} (Me₂ViSiO_{1/2})_{0.20},

and 0.034 g of 1,3-divinyltetramethyldisiloxane solution of 1,3-divinyltetramethyldisiloxane complex of platinum (content of platinum metal = 4000 ppm) were introduced and uniformly stirred at room temperature (25°C) to prepare a toluene solution of the resinous organopolysiloxane (3) containing 10 ppm by mass unit as platinum metal. Furthermore, the softening point of the resinous organopolysiloxane (3) was 100°C, and the melt viscosity at 100°C was 100 Pa·s.

### [Reference Example 4]

The toluene solution of the crosslinked organosiloxane (1) prepared in Reference Example 1 was introduced into a twin-screw kneader heated to 150°C, the toluene was removed, and the obtained organosiloxane block copolymer (1) was cooled while being pulverized by a ball mill to prepare hot meltable silicone fine particles (1) with indefinite shape. The fine particles were observed using a light microscope, and the particle size was 1000 to 3000 µm, and the average particle size was 1500 µm.

### [Reference Example 5]

The toluene solution of the crosslinked organosiloxane (1) prepared in Reference Example 1 was formed into fine particles while removing the toluene by spray drying at 40°C to prepare spherical hot meltable silicone fine particles (2). The fine particles were observed using a light microscope, and the particle size was 5 to 10 µm, and the average particle size was 7.5 µm.

### [Reference Example 6]

The toluene solution of the organosiloxane block copolymer (2) prepared in Reference Example 2 was introduced into a twin-screw kneader heated to 150°C, the toluene was removed, and the obtained organosiloxane block copolymer (2) was cooled while being pulverized by a ball mill to prepare hot meltable silicone fine particles (3) with indefinite shape. The fine particles were observed using a light microscope, and the particle size was 1000 to 3000 µm, and the average particle size was 1600 µm.

### [Reference Example 7]

The toluene solution of the organosiloxane block copolymer (2) prepared in Reference Example 2 was formed into particles while removing the toluene by spray drying at 40°C to prepare spherical hot meltable silicone fine particles (4). The fine particles were observed using a light microscope, and the particle size was 5 to 10 µm, and the average particle size was 6.5 µm.

### [Reference Example 8]

The toluene solution of the resinous organopolysiloxane (3) prepared in Reference Example 3 was formed into particles while removing the toluene by spray drying at 40°C to prepare spherical hot meltable silicone fine particles (5). The fine particles were observed using a light microscope, and the particle size was 5 to 10 µm, and the average particle size was 7.9 µm.

### [Practical Example 1]

89.3 g of hot meltable silicone fine particles (1), 5.35 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

5.35 g {at an amount where the silicon-bonded hydrogen atoms in the diphenylsiloxane and this organopolysiloxane are 1.0 mol with regard to 1 mol of vinyl groups in the silicone fine particles (1)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 300 ppm in terms of mass units with regard to the present composition), and 402 g of spherical silica (HS-202 manufacutred by Nippon Steel & Sumikin Materials Co., Ltd. Micron Company) with an average particle size of 15 µm were introduced into a laboratory mill at once, and stirring was performed for 1 minute at room temperature (25°C) to prepare a uniform and white curable granular silicone composition (1). Next, the composition was tableted by a tableting machine to prepare a cylindrical pellet with a diameter of 14 mm and height of 22 mm.

### [Practical Example 2]

89.3 g of hot meltable silicone fine particles (2), 5.35 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

5.35 g {at an amount where the silicon-bonded hydrogen atoms in the diphenylsiloxane and this organopolysiloxane are 1.0 mol with regard to 1 mol of vinyl groups in the silicone fine particles (2)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 300 ppm in terms of mass units with regard to the present composition), and 402 g of spherical silica (HS-202 manufacutred by Nippon Steel & Sumikin Materials Co., Ltd. Micron Company) with an average particle size of 15 µm were introduced into a laboratory mill at once, and stirring was performed for 1 minute at room temperature (25°C) to prepare a uniform and white curable granular silicone composition. Next, the composition was tableted by a tableting machine to prepare a cylindrical pellet with a diameter of 14 mm and height of 22 mm.

### [Practical Example 3]

78.2 g of hot meltable silicone fine particles (5), 10.9 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

10.9 g {at an amount where the silicon-bonded hydrogen atoms in the diphenylsiloxane and this organopolysiloxane are 1.0 mol with regard to 1 mol of vinyl groups in the silicone fine particles (5)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

and 976.6 g of spherical silica (HS-202 manufacutred by Nippon Steel & Sumikin Materials Co., Ltd. Micron Company) with an average particle size of 15 µm were introduced into a laboratory mill at once, and stirring was performed for 1 minute at room temperature (25°C) to prepare a uniform and white curable granular silicone composition. Next, the composition was tableted by a tableting machine to prepare a cylindrical pellet with a diameter of 14 mm and height of 22 mm.

### [Comparative Example 1]

35.1 g of 55 mass%-toluene solution of resinous organopolysiloxane in a white solid form at 25°C and represented by the following average unit formula:

(PhSiO_{3/2})_{0.80} (Me₂ViSiO_{1/2})_{0.20},

103.0 g of 50 mass%-toluene solution of resinous organopolysiloxane in a white solid form at 25°C and represented by the following average unit formula:

(MeViSiO_{2/2})_{0.25} (Ph₂SiO_{2/2})_{0.30} (PhSiO_{3/2})_{0.45} (HO_{1/2})_{0.02},

and 23.6 g {at an amount where silicon-bonded hydrogen atoms in this diphenylsiloxane are 1.1 mol with regard to a total of 1 mol of vinyl groups in the two types of resinous organopolysiloxanes} of diphenylsiloxane capped at both molecular terminals with dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H

were mixed, and then pressure stripping was performed at 90°C and toluene was removed to prepare a liquid mixture.

Next, 0.040 g (at an amount where platinum metal is 10 ppm by mass unit with regard to the liquid mixture) of 1,3-divinyltetramethyldisiloxane solution of 1,3-divinyltetramethyldisiloxane complex of platinum (content of platinum metal = approximately 4000 ppm), and 600 g of spherical silica (HS-202 manufactured by Nippon Steel & Sumikin Materials Co., Ltd. Micron Company) with an average particle size of 15 µm were added to 100 g of the liquid mixture, and then heating was performed for 20 minutes at 100°C to prepare a milky white solid curable silicone composition with low surface tackiness at room temperature (25°C).

### [Comparative Example 2]

The toluene solution of the organosiloxane block copolymer (1) prepared in Reference Example 1 was subject to pressure stripping at 90°C and toluene was removed to prepare a solid organosiloxane block copolymer (1) at room temperature (25°C). Next, 89.3 g of the organosiloxane block copolymer (1), 5.35 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

5.35 g {at an amount where the total silicon-bonded hydrogen atoms in the diphenylsiloxane and the present component are 1.0 mol with regard to 1 mol of vinyl groups in the organosiloxane block copolymer (1)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 800 ppm in terms of mass units with regard to the present composition), and 402 g of spherical silica (HS-202 manufacutred by Nippon Steel & Sumikin Materials Co., Ltd. Micron Company) with an average particle size of 15 µm were mixed for 20 minutes using a Ross mixer heated to 80°C to prepare a milky white solid curable silicone composition with low surface tackiness at room temperature (25°C).

### [Comparative Example 3]

The toluene solution of the organosiloxane block copolymer (1) prepared in Reference Example 1 was subject to pressure stripping at 90°C and toluene was removed to prepare a solid organosiloxane block copolymer (1) at room temperature (25°C). Next, 89.3 g of the organosiloxane block copolymer (1), 5.35 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

5.35 g {at an amount where the total silicon-bonded hydrogen atoms in the diphenylsiloxane and the present component are 1.0 mol with regard to 1 mol of vinyl groups in the organosiloxane block copolymer (1)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 800 ppm in terms of mass units with regard to the present composition), and 402 g of spherical silica (HS-202 manufacutred by Nippon Steel & Sumikin Materials Co., Ltd. Micron Company) with an average particle size of 15 µm were mixed for 20 minutes using a Ross mixer heated to 100°C, and the product was gelled.

### [Comparative Example 4]

153.1 g of 50 mass%-toluene solution of the organosiloxane block copolymer (1) prepared in Reference Example 1, 5.35 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

5.35 g {at an amount where the total silicon-bonded hydrogen atoms in the diphenylsiloxane and the present component are 1.0 mol with regard to 1 mol of vinyl groups in the organosiloxane block copolymer (1)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 800 ppm in terms of mass units with regard to the present composition), and 402 g of spherical silica (HS-202 manufacutred by Nippon Steel & Sumikin Materials Co., Ltd. Micron Company) with an average particle size of 15 µm were introduced into a Ross mixer and stirred at room temperature (25°C) to prepare a toluene solution of a white curable silicone composition. Next, when the solution was subject to pressure stripping at 90°C and toluene was removed, the product gelled.

### [Comparative Example 5]

153.1 g of 50 mass%-toluene solution of the organosiloxane block copolymer (1) prepared in Reference Example 1, 5.35 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

5.35 g {at an amount where the total silicon-bonded hydrogen atoms in the diphenylsiloxane and the present component are 1.0 mol with regard to 1 mol of vinyl groups in the organosiloxane block copolymer (1)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 800 ppm in terms of mass units with regard to the present composition), and 402 g of spherical silica (HS-202 manufacutred by Nippon Steel & Sumikin Materials Co., Ltd. Micron Company) with an average particle size of 15 µm were introduced into a Ross mixer and stirred at room temperature (25°C) to prepare a toluene solution of a white curable silicone composition. Next, the solution was spray dried at 40°C to attempt removing toluene, but the filler component began to precipitate in the spray drying step, and a uniform curable granular silicone composition could not be obtained.

**[Table 1]**

| | | Practical Example 1 | Practical Example 2 | Practical Example 3 | Comparative Examples 1 | Comparative Examples 2 | Comparative Examples 3 | Comparative Examples 4 | Comparative Examples 5 |
|---|---|---|---|---|---|---|---|---|---|
| Characteristics of the curable granular silicone composition | | | | | | | Unmeasurable because gelled | Unmeasurable because gelled | Unmeasurable due to filler separation |
| | Softening point (°C) | 65 | 65 | 90 | 55 | 65 | | | |
| | Melt viscosity (Pa·s) | 2620 | 1340 | 1840 | 830 | 12200 | | | |
| | Curing characteristics | | | | | | | | |
| | T₁ (seconds) | 39 | 40 | 44 | 29 | 11 | | | |
| | Curing characteristics | | | | | | | | |
| | T₉₀ (seconds) | 108 | 111 | 127 | 150 | 54 | | | |
| | Moldability | Good | Good | Good | Peeled | Not filled | | | |
| Characteristics of the cured product | | | | | | | | | |
| | Hardness | 88 | 91 | 92 | 90 | 90 | | | |
| | Bending strength (MPa) | 27.2 | 41.4 | 35.1 | 34.4 | 38.7 | | | |

### [Practical Example 4]

97.6 g of the hot meltable silicone fine particles (2), 2.4 g of 2,5-dimethyl-2,5-di(tert-butylperoxy) hexane (with a 10-hour half-life temperature of 118°C.), and 395 g of spherical silica (HS-202 manufacutred by Nippon Steel & Sumikin Materials Co., Ltd. Micron Company) with an average particle size of 15 µm were introduced into a laboratory mill at once, and stirring was performed for 1 minute at room temperature (25°C) to prepare a white and uniform curable granular silicone composition. Next, the composition was tableted by a tableting machine to prepare a cylindrical pellet with a diameter of 14 mm and height of 22 mm.

### [Practical Example 5]

97.6 g of the hot meltable silicone fine particles (3), 2.4 g of 2,5-dimethyl-2,5-di(tert-butylperoxy) hexane (with a 10-hour half-life temperature of 118°C.), and 395 g of spherical silica (HS-202 manufacutred by Nippon Steel & Sumikin Materials Co., Ltd. Micron Company) with an average particle size of 15 µm were introduced into a laboratory mill at once, and stirring was performed for 1 minute at room temperature (25°C) to prepare a white and uniform curable granular silicone composition. Next, the composition was tableted by a tableting machine to prepare a cylindrical pellet with a diameter of 14 mm and height of 22 mm.

**[Table 2]**

| | | Practical Example 4 | Practical Example 5 |
|---|---|---|---|
| Characteristics of the curable granular silicone composition | | | |
| | Softening point (°C) | 60 | 55 |
| | Melt viscosity (Pa·s) | 1440 | 4790 |
| | Curing characteristics T₁ (seconds) | 28 | 37 |
| | Curing characteristics T₉₀ (seconds) | 122 | 135 |
| | Moldability | Good | Good |
| Characteristics of the cured product | | | |
| | Hardness | 91 | 83 |
| | Bending strength (MPa) | 38.5 | 24.5 |

### [Practical Example 6]

89.3 g of hot meltable silicone fine particles (1), 8.9 g of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

1.8 g {at an amount where the total silicon-bonded hydrogen atoms in the diphenylsiloxane and the present component are 1.0 mol with regard to 1 mol of vinyl groups in the silicone fine particles (1)} of branched chain organopolysiloxane with two or more silicon-bonded hydrogen atoms in a molecule, having a viscosity of 25 mPa·s (silicon-bonded hydrogen atom content = 0.65 mass%) and representd by the following average unit formula:

(PhSiO_{3/2})_{0.4} (HMe₂SiO_{1/2})_{0.6},

1-ethynyl-1-cyclohexanol (at an amount of 300 ppm in terms of mass units with regard to the present composition), 192 g of spherical silica (HS-202 manufacutred by Nippon Steel & Sumikin Materials Co., Ltd. Micron Company) with an average particle size of 15 µm, 156 g of titanium oxide (SX-3103 manufactured by Sakai Chemical Industry Co., Ltd.) with an average particle size of 0.5 µm, and 54 g of glass fiber (EFDE 50-01 manufactured by Central Glass Co., Ltd.) with a fiber diameter of 6 µm and fiber length of 50 µm were introduced into a laboratory mill at once, and stirring was performed for 1 minute at room temperature (25°C) to prepare a white and uniform curable granular silicone composition. Next, the composition was tableted by a tableting machine to prepare a cylindrical pellet with a diameter of 14 mm and height of 22 mm.

### [Practical Example 7]

89.3 g of hot meltable silicone fine particles (2), 10.7 g {at an amount where silicon-bonded hydrogen atoms in the present component are 1.0 mol with regard to 1 mol of vinyl groups in the silicone fine particles (2)} of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

1-ethynyl-1-cyclohexanol (at an amount of 300 ppm in terms of mass units with regard to the present composition), 192 g of spherical silica (HS-202 manufacutred by Nippon Steel & Sumikin Materials Co., Ltd. Micron Company) with an average particle size of 15 µm, 156 g of titanium oxide (SX-3103 manufactured by Sakai Chemical Industry Co., Ltd.) with an average particle size of 0.5 µm, and 54 g of glass fiber (EFDE 50-01 manufactured by Central Glass Co., Ltd.) with a fiber diameter of 6 µm and fiber length of 50 µm were introduced into a laboratory mill at once, and stirring was performed for 1 minute at room temperature (25°C) to prepare a white and uniform curable granular silicone composition. Next, the composition was tableted by a tableting machine to prepare a cylindrical pellet with a diameter of 14 mm and height of 22 mm.

### [Practical Example 8]

90.9 g of hot meltable silicone fine particles (4), 9.1 g {at an amount where silicon-bonded hydrogen atoms in the present component are 2.4 mol with regard to 1 mol of vinyl groups in the silicone fine particles (4)} of branched chain organopolysiloxane with two or more silicon-bonded hydrogen atoms in a molecule, having a viscosity of 25 mPa·s (silicon-bonded hydrogen atom content = 0.65 mass%) and represented by the following average unit formula:

(PhSiO_{3/2})_{0.4} (HMe₂SiO_{1/2})_{0.6},

1-ethynyl-1-cyclohexanol (at an amount of 800 ppm in terms of mass units with regard to the present composition), 227 g of spherical silica (HS-202 manufacutred by Nippon Steel & Sumikin Materials Co., Ltd. Micron Company) with an average particle size of 15 µm, and 136 g of titanium oxide (SX-3103 manufactured by Sakai Chemical Industry Co., Ltd.) with an average particle size of 0.5 µm were introduced into a laboratory mill at once, and stirring was performed for 1 minute at room temperature (25°C) to prepare a white and uniform curable granular silicone composition. Next, the composition was tableted by a tableting machine to prepare a cylindrical pellet with a diameter of 14 mm and height of 22 mm.

**[Table 3]**

| | | Practical Example 6 | Practical Example 7 | Practical Example 8 |
|---|---|---|---|---|
| Characteristics of the curable granular silicone composition | | | | |
| | Softening point (°C) | 65 | 60 | 55 |
| | Melt viscosity (Pa·s) | 2840 | 1450 | 4230 |
| | Curing characteristics T₁ (seconds) | 42 | 44 | 26 |
| | Curing characteristics T₉₀ (seconds) | 117 | 129 | 139 |
| | Moldability | Good | Good | Good |
| Characteristics of the cured product | | | | |
| | Hardness | 88 | 87 | 82 |
| | Bending strength (MPa) | 29.2 | 34.2 | 27.6 |
| | Total luminous reflectance (%) | 94.1 | 94.7 | 94.5 |

### [Practical Example 9]

89.3 g of hot meltable silicone fine particles (5), 10.7 g {at an amount where silicon-bonded hydrogen atoms in the present component are 1.0 mol with regard to 1 mol of vinyl groups in the silicone fine particles (5)} of diphenylsiloxane capped at both molecular terminals by dimethylhydrogensiloxy groups, having a viscosity of 5 mPa·s (silicon-bonded hydrogen atom content = 0.6 mass%) and represented by the following formula:

HMe₂SiO(Ph₂SiO)SiMe₂H,

1-ethynyl-1-cyclohexanol (at an amount of 300 ppm in terms of mass units with regard to the present composition), and 1160.7 g of spherical alumina (AS-40 manufactured by Showa Denko K.K.) with an average particle size of 12 µm were introduced into a laboratory mill at once, and stirring was performed for 1 minute at room temperature (25°C) to prepare a white and uniform curable granular silicone composition. Next, the composition was tableted by a tableting machine to prepare a cylindrical pellet with a diameter of 14 mm and height of 22 mm.

**[Table 4]**

| | | Practical Example 9 |
|---|---|---|
| Characteristics of the curable granular silicone composition | | |
| | Softening point (°C) | 75 |
| | Melt viscosity (Pa·s) | 3220 |
| | Curing characteristics T₁ (seconds) | 33 |
| | Curing characteristics T₉₀ (seconds) | 124 |
| | Moldability | Good |
| Characteristics of the cured product | | |
| | Hardness | 90 |
| | Bending strength (MPa) | 29.3 |
| | Heat conductivity (W/m·k) | 2.2 |

### INDUSTRIAL APPLICABILITY

The present composition has hot melt properties and has excellent handling workability and curability, and is therefore preferable as a sealing agent or underfill agent for semiconductors; sealing agent or underfill agent for power semiconductors such as SiC, GaN, and the like; sealing agent or light reflecting material for optical semiconductors such as light emitting diodes, photodiodes, phototransistors, laser diodes, and the like; electrical and electronic adhesive, potting agent, protecting agent, and coating agent. Furthermore, the present composition has hot melt properties, and is therefore also preferable as a material for transfer molding, compression molding, or injection molding.

## Claims

1. A curable granular silicone composition comprising:
(A) hot meltable silicone fine particles having a hydrosilylation reactive group and/or radical reactive group, with a softening point of 30°C or higher;
(B) a filler that does not have a softening point or does not soften below the softening point of the aforementioned component (A); and
(C) a curing agent.

2. The curable granular silicone composition according to Claim 1, wherein the hydrosilylation reactive group in component (A) is an alkenyl group with 2 to 20 carbon atoms and/or a silicon-bonded hydrogen atom.

3. The curable granular silicone composition according to Claim 1, wherein the radical reactive group in component (A) is an alkyl group with 1 to 20 carbon atoms, alkenyl group with 2 to 20 carbon atoms, group containing acrylic, group containing methacrylic, or silicon-bonded hydrogen atom.

4. The curable granular silicone composition according to any one of Claims 1 to 3, wherein component (A) is silicone fine particles including: (A₁) a resinouus organopolysiloxane; (A₂) a crosslinked organopolysiloxane formed by partially crosslinking at least one type of organopolysiloxane; (A₃) a block copolymer including a resinous organosiloxane block and linear organosiloxane block; or a mixture of two types or more thereof.

5. The curable granular silicone composition according to Claim 1, wherein the average particle size of component (A) is 1 to 5000 µm.

6. The curable granular silicone composition according to Claim 1, wherein component (B) is a reinforcing filler, white pigment, heat conductive filler, electrically conductive filler, phosphor, or a mixture of two types or more thereof.

7. The curable granular silicone composition according to Claim 1, wherein the average particle size of component (B) is 1 nm to 500 µm.

8. The curable granular silicone composition according to Claim 1, wherein the amount of component (B) is 10 to 3000 parts by mass with regard to 100 parts by mass of component (A).

9. The curable granular silicone composition according to Claim 1, wherein the curable granular silicone composition is in a pellet form.

10. A method for manufacturing a curable granular silicone composition, **characterized by** powder mixing components comprising:
(A) hot meltable silicone fine particles having a hydrosilylation reactive group and/or radical reactive group, with a softening point of 30°C or higher;
(B) a filler that does not have a softening point or does not soften below the softening point of the aforementioned component (A); and
(C) a curing agent,
at a temperature below the softening point of component (A).

11. A method for molding a cured product, **characterized by** comprising the following steps (I) to (III):
(I) a step of heating and melting the curable granular silicone composition according to any one of Claims 1 to 8 at a temperature higher than the softening point of component (A);
(II) a step of injecting the curable silicone composition obtained in step (I) into a metal mold; and
(III) a step of curing the curable silicone composition injected in step (II).
